# EUROPÄISCHE PATENTANMELDUNG

(11) **EP 1 962 571 A2**
(43) Veröffentlichungstag der Anmeldung: **27.08.2008**
(21) Anmeldenummer: 08100414.5
(22) Anmeldetag: 14.01.2008
(51) Int. Cl.: H05K 13/02

(54) **Vorrichtung und Verfahren zum Bereitstellen von Flächenmagazinen, Bestücksystem**

(30) Priorität: 22.02.2007 DE 102007008755
(71) Anmelder: SIEMENS AKTIENGESELLSCHAFT, 80333 München (DE)
(72) Erfinder: Fichtner-Pflaum, Gerolf, 76703, Kraichtal (DE); Heuberger, Franz, 69126, Heidelberg (DE)
(74) Vertreter: Maier, Daniel Oliver

(57) **Zusammenfassung**

Diese Anmeldung beschreibt eine Vorrichtung und ein Verfahren zum Bereitstellen von Flächenmagazinen (148) insbesondere für einen Bestückautomaten (110). Die Vorrichtung weist auf eine Ladeeinrichtung (150) zum Beladen und Entladen von Flächenmagazinen (148), eine Speichereinrichtung (170), welche eine Mehrzahl von Speicherpositionen zum Speichern jeweils eines Flächenmagazins (148) aufweist, wobei die Speichereinrichtung (170) mit der Ladeeinrichtung (150) derart gekoppelt ist, dass Flächenmagazine (148) zwischen der Ladeeinrichtung (150) und verschiedenen Speicherpositionen transferierbar sind, und eine Bereitstellungseinrichtung (190), welche mit der Speichereinrichtung (170) derart gekoppelt ist, dass Flächenmagazine (148) zwischen verschiedenen Speicherpositionen und einer Bereitstellungsposition (193) der Bereitstellungseinrichtung (190) transferierbar sind. Dabei sind die Ladeeinrichtung (150), die Speichereinrichtung (170) und die Bereitstellungseinrichtung (190)derart ausgestaltet, dass wie auch im beschriebenen Verfahren ein Transferieren und ein Entladen eines aus der Speichereinrichtung (170) ausgeschleusten Flächenmagazins (148) sowie ein Beladen der Ladeeinrichtung (150) mit einem anderen Flächenmagazin (148) gerade dann erfolgen kann, wenn elektronische Bauelemente (125) aus einem weiteren Flächenmagazin (148) entnommen werden, welches sich gerade in der Bereitstellungseinrichtung (190) befindet. Auf diese Weise kann ein kontinuierlicher Bestückbetrieb auch bei Verwendung von Flächenmagazinen (148) aufrecht erhalten werden.

## Beschreibung

Die vorliegende Erfindung betrifft das Gebiet der automatischen Bestückung von Bauelementeträgern mit elektronischen Bauelementen. Die vorliegende Erfindung betrifft insbesondere die Zuführung von Flächenmagazinen, in denen jeweils eine Vielzahl von elektronischen Bauelementen abgelegt ist, für einen Bestückautomaten, so dass die Bauelemente von einem Bestückkopf des Bestückautomaten aus dem jeweiligen Flächenmagazin entnommen und in bekannter weise auf einen zu bestückenden Bauelementeträger aufgesetzt werden können.

Die Bestückung von Bauelementeträgern bzw. Leiterplatten mit elektronischen Bauelementen erfolgt üblicherweise mittel sog. Bestückautomaten. Dabei werden die Bauelemente von einer Bauelement-Zuführeinrichtung an bestimmten Abholpositionen bereitgestellt und von dort von einem Bestückkopf abgeholt. Der Bestückkopf kann eine oder auch mehrere Bauelement-Haltevorrichtungen aufweisen, so dass gleichzeitig ein oder mehrere Bauelemente transportiert werden können. Der Bestückkopf kann mittels eines Positioniersystems innerhalb eines vorgegebenen Arbeitsbereiches positioniert werden. Nach dem Abholen werden die Bauelemente von dem Bestückkopf zu einer Bestückposition transportiert und auf dem zu bestückenden Substrat an durch entsprechende Anschlussflächen definierte Einbaupositionen aufgesetzt.

Das Zuführen der elektronischen Bauelemente für einen Bestückprozess kann auf verschiedene Arten erfolgen. So können beispielsweise Bauelemente, die in Taschen von so genannten Bauelement-Gurten verpackt sind, durch ein schrittweises Abwickeln eines Bauelement-Gurtes zeitlich nacheinander an einer vorgegebenen Abholposition bereitgestellt werden.

Außerdem können Bauelemente, die in einem Flächenmagazin bevorzugt in Form eines zweidimensionalen Rasters aufbewahrt werden, durch ein einfaches Bereitstellen des Flächenmagazins in einem Bereich neben dem eigentlichen Bestückfeld eines Bestückautomaten dem Bestückprozess zugeführt werden. In diesem Fall werden die einzelnen elektronischen Bauelemente von dem Bestückkopf des Bestückautomaten jeweils an einer anderen Abholposition aufgenommen. Die Bereitstellung von Bauelementen mittels eines geeigneten Flächenmagazins hat den Vorteil, dass im Vergleich zu einer Bereitstellung mittels eines Bauelement-Gurtes deutlich weniger Abfall produziert wird. Anders als die entleerten Bauelement-Gurte können die Flächenmagazine nämlich unter Umständen sogar wieder verwendet werden. Dies ist bei einem Gurt nicht möglich, der beim Zuführen üblicherweise sukzessive in einzelne Gurtstücke geschnitten wird.

Bei der Bauelement-Zuführung mittels Flächenmagazinen, in denen jeweils eine Mehrzahl von Bauelementen aufbewahrt sind, können gleichzeitig mehrere Flächenmagazine vertikal gestapelt in einem entsprechenden Container aufbewahrt werden. Währen des Bestückbetriebs werden die Flächenmagazine nacheinander aus dem Container entnommen und die darin aufbewahrten Bauelemente dem Bestückprozess bereit gestellt.

Die EP 1344441 bzw. die auf dieselbe japanische Prioritätsanmeldung JP 200037980 zurückgehende US 2004/0031768 A1 offenbaren einen Container für Flächenmagazine für elektronische Bauelemente sowie eine zugehörige Bereitstellungsvorrichtung für Flächenmagazine und Bestückautomaten. Der Container ermöglicht eine Platz sparende Anordnung von mehreren Flächenmagazinen in Form eines Stapels. Der Container weist einen Rahmen auf, der an den Außenecken vier Pfosten und äußere Seitenplatten umfasst. Die Flächenmagazine können aus zwei um 90° gegeneinander versetzten Richtungen in den Container eingeführt und von diesem entnommen werden. Trennplatten im Inneren des Containers können in verschiedenen Positionen angebracht werden, so dass eine variable Aufteilung des Containers in verschiedene Unterbereiche zur Aufnahme von unterschiedlich hohen Flächenmagazinen möglich ist. Der Container kann mittels eines Lifts auf verschiedenen Arbeitshöhen angehoben oder abgesenkt werden. Ein Laden des Containers mit Flächenmagazinen bzw. ein Bereitstellen von Flächenmagazinen für ein Bestücken erfolgt sequentiell, ebenso wie der Abtransport eines leeren Magazine nach dem Bestücken bzw. das Entladen des Containers. Das hat den Nachteil, dass im Prinzip kein lückenloser Betrieb und damit keine zügige Bestückung von Bauelementträger möglich sind.

Die US 6,616,401 B2 offenbart eine Zuführeinrichtung für in Flächenmagazinen aufbewahrte elektronische Bauelemente. Die Zuführeinrichtung weist einen Lift auf, mit dem ein Flächenmagazin aus unterschiedlichen Höhenlagen aus einem Container herausgezogen und in eine Abholebene angehoben werden kann. Aus dieser Abholebene werden die Bauelemente dann von einem Bestückkopf aufgenommen und auf eine in der gleichen Ebene angeordnete Leiterplatte bestückt. Nach einer zumindest teilweisen Entleerung des in die Abholebene angehobenen Flächenmagazins wird dieses von dem Lift in einen Entladebereich der Zuführeinrichtung transferiert. Die genannte Zuführeinrichtung hat jedoch den Nachteil, dass beim Bereitstellen eines neuen Flächenmagazins zunächst das alte Magazin von der Abholebene entfernt und in den Entladebereich transferiert werden muss, bevor der Lift zum Herausnehmen eines neuen Flächenmagazins und zum Anheben desselben in die Abholebene zur Verfügung steht.

Der Erfindung liegt die Aufgabe zugrunde, die Bereitstellung von Flächenmagazinen für einen Bestückautomaten derart zu verbessern, so dass eine zügige Bestückung von Bauelementeträgern möglich ist.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird eine Vorrichtung zum Bereitstellen von Flächenmagazinen beschrieben, welche insbesondere zum temporären Bereitstellen von mit elektronischen Bauelementen beladenen Flächenmagazinen für einen Bestückautomaten zum Zwecke der automatischen Bestückung von Bauelementeträgern mit elektronischen Bauelementen geeignet ist. Die Vorrichtung weist auf (a) eine Ladeeinrichtung zum Beladen und Entladen von Flächenmagazinen, (b) eine Speichereinrichtung, welche eine Mehrzahl von Speicherpositionen zum Speichern jeweils eines Flächenmagazins aufweist, wobei die Speichereinrichtung mit der Ladeeinrichtung derart gekoppelt ist, dass Flächenmagazine zwischen der Ladeeinrichtung und verschiedenen Speicherpositionen transferierbar sind, und (c) eine Bereitstellungseinrichtung, welche mit der Speichereinrichtung derart gekoppelt ist, dass Flächenmagazine zwischen verschiedenen Speicherpositionen und einer Bereitstellungsposition der Bereitstellungseinrichtung transferierbar sind. Dabei (d) sind die Ladeeinrichtung, die Speichereinrichtung und die Bereitstellungseinrichtung derart ausgestaltet, dass ein Austausch von Flächenmagazinen zwischen der Ladeeinrichtung und der Speichereinrichtung in einem Zeitfenster durchführbar ist, in welchem elektronische Bauelementen aus einem anderen in der Bereitstellungseinrichtung bereitgestellten Flächenmagazin entnommen werden.

Der beschriebenen Flächenmagazin-Bereitstellungsvorrichtung liegt die Erkenntnis zugrunde, dass durch eine selektive Koppelbarkeit zwischen verschiedenen Speicherpositionen und der Bereitstellungseinrichtung ein Austausch von Flächenmagazinen innerhalb einer besonders kurzen Zeitspanne erfolgen kann. Der Austausch kann nicht nur dann erfolgen, wenn das erste Flächenmagazin vollständig entleert ist. Der Austausch kann auch dann erfolgen, wenn mit dem zweiten Flächenmagazin ein anderer Typ von Bauelement bereitgestellt werden soll. Dies bedeutet, dass die einzelnen Flächenmagazine, die sich in der Speichereinrichtung befinden und die verschiedene Typen von Bauelementen enthalten können, sukzessive entleert werden. Dabei kann ein Flächenmagazin bis zur vollständigen Entleerung nahezu beliebig oft an der Bereitstellungsposition bereitgestellt und von dieser wieder entfernt werden. Selbstverständlich macht eine Bereitstellung in diesem Zusammenhang nur dann Sinn, wenn zumindest ein Bauelement entnommen wird. Dies bedeutet, dass die maximale Anzahl an Bereitstellungsvorgängen durch die Anzahl der in dem jeweiligen Flächenmagazin befindlichen Bauelemente gegeben ist.

Die Verwendung der beschriebenen Ladeeinrichtung hat den Vorteil, dass der Bestückbetrieb auch dann nicht unterbrochen werden muss, wenn ggf. vollständig entleerte Flächenmagazine von der gesamten Flächenmagazin-Bereitstellungsvorrichtung entfernt und/oder neue zumindest teilweise mit Bauelementen befüllte Flächenmagazine der Bereitstellungsvorrichtung zur Verfügung gestellt werden. Ein derartiges Ein- bzw. Ausschleusen von Flächenmagazinen kann somit gerade dann erfolgen, wenn sich ein Flächenmagazin zum Zwecke der Entnahme von Bauelementen in der Bereitstellungseinrichtung befindet, so dass der Bestückbetrieb eines Bestückautomaten nicht unterbrochen werden muss. Dies ermöglicht auf vorteilhafte Weise einen Dauerbetrieb der gesamten Flächenmagazin-Bereitstellungsvorrichtung.

Die beschriebene Speichereinrichtung ermöglicht somit eine gewisse Entkopplung zwischen der Bereitstellungseinrichtung und der Ladeeinrichtung, so dass in jeweils unterschiedlichen Zeitfenstern auf der einen Seite ein Austausch von Flächenmagazinen zwischen der Speichereinrichtung und der Bereitstellungseinrichtung und auf der anderen Seite ein Austausch von Flächenmagazinen zwischen der Speichereinrichtung und der Ladeeinrichtung erfolgen kann.

Durch das oben beschriebene geschickte Zeitmanagement dieser beiden Austauschvorgänge kann die Bestückleistung eines Bestückautomaten deutlich erhöht werden. Unter dem Begriff Bestückleistung ist in diesem Zusammenhang die maximale Anzahl an Bauelementen zu verstehen, die innerhalb einer bestimmten Zeiteinheit an vorgegebenen Bauelement-Einbaupositionen auf Bauelementeträgern aufgesetzt werden können. Ingesamt können mit der beschriebenen Flächenmagazin-Bereitstellungsvorrichtung ähnlich hohe Bestückleistungen erzielt werden, die sonst nur unter Verwendung von sog. Gurtfördereinrichtungen erreichbar sind.

Gemäß einem Ausführungsbeispiel der Erfindung nach Anspruch 2 sind die Ladeeinrichtung und die Bereitstellungseinrichtung in Bezug auf die Speichereinrichtung auf einander gegenüberliegenden Seiten angeordnet. Dies hat den Vorteil, dass sämtliche Transfervorgänge von Flächenmagazinen entlang einer gemeinsamen Zuführachse erfolgen. Damit kann die beschriebene Vorrichtung zum Bereitstellen von Flächenmagazinen auf vergleichsweise einfache Weise realisiert werden.

Gemäß einem weiteren Ausführungsbeispiel der Erfindung nach Anspruch 3 sind die verschiedenen Speicherpositionen zueinander in vertikaler Richtung übereinander angeordnet. Dies hat den Vorteil, dass insbesondere Flächenmagazine, die eine flache Bauweise aufweisen, auf besonders Platz sparende Weise in der Speichereinrichtung angeordnet werden können.

Gemäß einem weiteren Ausführungsbeispiel der Erfindung nach Anspruch 4 weist die Vorrichtung zusätzlich auf eine Heb- und Senkeinrichtung zum vertikalen Verschieben der Speichereinrichtung in Bezug auf die Ladeeinrichtung und/oder in Bezug auf die Bereitstellungseinrichtung.

Durch eine entsprechende Höhenpositionierung der Speichereinrichtung kann somit jede beliebige Speicherposition auf eine Ebene mit der Bereitstellungsposition gefahren werden. Somit kann ein Flächenmagazin-Transfer zwischen der Speichereinrichtung und der Bereitstellungseinrichtung durch eine einfache horizontale Verschiebung des Flächenmagazins erfolgen. Das gleiche gilt für einen Flächenmagazin-Transfer zwischen der Ladeeinrichtung und der Speichereinrichtung.

Die horizontale Verschiebung kann auf vorteilhafte Weise durch horizontal verschiebbare Mitnehmerelemente erfolgen, welche beispielsweise in eine Aussparung des Flächenmagazins und/oder in eine Aussparung eines Trägerelements eingreifen, an dem das Flächenmagazin beispielsweise mittels Magneten lösbar befestigt ist.

Gemäß einem weiteren Ausführungsbeispiel der Erfindung nach Anspruch 5 weist die Ladeeinrichtung ein mechanisches Abschirmelement auf, welches (a) in einer Öffnungsposition ein einfaches Be- und Entladen von Flächenmagazinen durch eine Bedienperson ermöglicht und welches (b) in einer Schließposition ein mechanisches Schutzschild darstellt. Das mechanische Abschirmelement kann beispielsweise eine verschiebbare oder eine schwenkbare Abdeckklappe sein.

Der mechanische Schutzschild kann in der Schließposition auf einfache und zugleich effektive Weise ein versehentliches Hineingreifen einer Bedienperson in den Ladebereich der Ladeeinrichtung verhindern. Somit ist sowohl ein für Bedienpersonen gefahrloses als auch für den gesamten Zuführprozess fehlerfreies Ein- und Ausschleusen von Flächenmagazinen möglich.

In der Öffnungsposition ermöglicht der mechanische Schutzschild einen bequemen Zugriff auf den Ladebereich, so dass eine Bedienperson Flächenmagazine auf bequeme Art und Weise in die Ladeeinrichtung einlegen und/oder von der Ladeeinrichtung entfernen kann.

Das Schließen des mechanischen Schutzschildes kann automatisch ein Freigabesignal für eine Steuerung der Flächenmagazin-Bereitstellungsvorrichtung erzeugen. Auf diese Weise ist nach Einlegen eines neuen Flächenmagazins in die Ladeeinrichtung nach dem Schließen des Schutzschildes keine weitere Freigabeaktion der jeweiligen Bedienperson erforderlich, mit dem die Bedienperson ein korrektes Einlegen eines neuen Flächenmagazins quittiert.

Gemäß einem weiteren Ausführungsbeispiel der Erfindung nach Anspruch 6 weist die Flächenmagazin-Bereitstellungsvorrichtung zusätzlich ein Sicherheitssystem auf, welches mit dem mechanischen Schutzschild gekoppelt ist und welches derart eingerichtet ist, dass bei geöffnetem mechanischen Schutzschild ein Transfer eines Flächenmagazins von der Speichereinrichtung zu der Ladeeinrichtung verhindert wird.

Es wird ausdrücklich darauf hingewiesen, dass das beschriebene Sicherheitssystem von einem eventuell vorhandenen weiteren Sicherheitssystem entkoppelt ist, welches den Betrieb des Bestückautomaten und/oder den Flächenmagazin-Transfer zwischen der Speichereinrichtung und der Bereitstellungseinrichtung überwacht. Auf diese Weise kann gewährleistet werden, dass der Bestückbetrieb ohne Unterbrechung weitergeführt werden kann, auch wenn eine Bedienperson gerade ein zumindest teilweise mit Bauelementen befülltes Flächenmagazin in die Ladeeinrichtung einlegt oder ein zumindest teilweise entleertes Flächenmagazin aus der Ladeeinrichtung entnimmt.

Gemäß einem weiteren Ausführungsbeispiel der Erfindung nach Anspruch 7 weist die Ladeeinrichtung ein mechanisches Trennelement auf, welches (a) zwischen einer Öffnungsposition und einer Schließposition bewegbar ist und welches (b) in der Schließposition einen Ladebereich der Ladeeinrichtung von der Speichereinrichtung abtrennt. Dies hat den Vorteil, dass die Betriebssicherheit zusätzlich erhöht werden kann, da ein versehentliches Ausschleusen eines Flächenmagazins aus der Speichereinrichtung bei zumindest teilweise geöffneter Abdeckklappe zuverlässig verhindert werden kann.

Das Trennelement kann beispielsweise ein so genannter Trennschieber sein, welcher durch eine einfache vertikale Verschiebebewegung eine räumliche Trennung zwischen Ladebereich und Speichereinrichtung herstellt. Dies hat den Vorteil, dass der horizontale Platzbedarf für das Trennelement besonders niedrig ist. Damit kann eine zusätzliche Betriebssicherheit ohne nennenswerten zusätzlichen Platzbedarf für die Flächenmagazin-Bereitstellungsvorrichtung erreicht werden.

Die aktuelle Stellung des Trennelements kann zusammen mit der aktuellen Stellung des mechanischen Abschirmelements beispielsweise in dem oben beschriebenen Sicherheitssystem derart berücksichtigt werden, dass eine Betriebsunterbrechung nur dann erfolgt, wenn sowohl das Trennelement als auch das mechanische Abschirmelement geöffnet ist.

Gemäß einem weiteren Ausführungsbeispiel der Erfindung nach Anspruch 8 weist die Flächenmagazin-Bereitstellungsvorrichtung zusätzlich eine Anzeigeeinrichtung auf, welche mit der Ladeeinrichtung gekoppelt und derart eingerichtet ist, dass einer Bedienperson ein Hinweis bzw. ein Signal angezeigt wird, wenn sich ein zu entnehmendes Flächenmagazin in der Ladeeinrichtung befindet.

Die Anzeigeeinrichtung kann beispielsweise eine optische und/oder eine akustische Anzeige sein, welche geeignet ist eine Bedienperson zu informieren, wenn ein von der Speichereinrichtung zu der Ladeeinrichtung transferiertes Flächenmagazin zum Zwecke der Entnahme aus der Ladeeinheit bereitsteht.

Bevorzugt ist die Anzeigeeinrichtung eingerichtet, ein optisches Signal auszugeben, welches einer Bedienperson auch in einer größeren Maschinenhalle mit ggf. einer Vielzahl von zu bedienenden Bestückautomaten bzw. Flächenmagazin-Bereitstellungsvorrichtungen deutlicht anzeigt, wo sich das zu entnehmende Flächenmagazin befindet. Die Anzeigeeinrichtung kann auch Teil eines drahtlosen Kommunikationssystems sein, welches geeignet ist, über eine von der Bedienperson mitgeführte Empfangseinrichtung wie beispielsweise ein Mobiltelefon oder dergleichen, die Bedienperson über einen in der betreffenden Ladeeinrichtung vorzunehmenden Flächenmagazin-Austausch zuverlässig zu informieren.

Es wird darauf hingewiesen, dass als Anzeigeeinrichtung auch eine bereits vorhandene Anzeigerichtung genutzt werden kann. So eignet sich beispielsweise eine so genannte Störlampe, die typischerweise an herkömmlichen Bestückautomaten angebracht ist, um der Bedienperson einen Störzustand des Bestückautomaten optisch anzuzeigen. In diesem Fall wird also die Störlampe durch unterschiedliche Ereignisse angeschaltet. Dabei wird eine Bedienperson jedoch sofort erkennen, dass im Falle eines aus der Speichereinrichtung in die Ladeeinrichtung ausgeschleusten Flächenmagazins kein Störzustand des Bestückautomaten vorliegt.

Gemäß einem weiteren Ausführungsbeispiel der Erfindung nach Anspruch 9 weist die Bereitstellungseinrichtung einen Antrieb auf, welcher derart eingerichtet ist, dass ein bereitgestelltes Flächenmagazin schrittweise verschiebbar ist. Dies hat den Vorteil, dass die von einem Bestückkopf des Bestückautomaten zu entnehmenden Bauelemente, welche sich noch in dem Flächenmagazin befinden, in definierte Abholpositionen bewegt werden können. Auf diese Weise können die Verfahrwege des Bestückkopfes erheblich reduziert werden, so dass die Bestückleistung infolge von reduzierten Transportzeiten des Bestückkopfes erhöht wird.

Im Falle einer lediglich eindimensionalen Verschiebung des Flächenmagazins in Richtung eines entsprechenden Bestückautomaten liegen die Abholpositionen bevorzugt auf einer Reihe, die senkrecht zu der Verschieberichtung orientiert ist.

Die schrittweise Verschiebung kann ungeregelt oder geregelt erfolgen. Eine geregelte Verschiebung, welche einen höheren apparativen Aufwand in Bezug auf zu verwendende Sensorik erfordert, ermöglicht selbstverständlich eine größere Genauigkeit der Positionierung der Flächenmagazine. Bevorzugt erfolgt die Verschiebung in Schrittweiten, die kommensurabel zu dem Teilungsabstand der einzelnen Aufnahmen des Flächenmagazins sind.

Gemäß einem weiteren Ausführungsbeispiel der Erfindung nach Anspruch 10 weist die Flächenmagazin-Bereitstellungsvorrichtung zusätzlich eine Steuereinrichtung auf, welche derart eingerichtet ist, dass Flächenmagazine zum Zwecke eines Austauschs in der Ladeeinrichtung jeweils in einem Zeitfenster in der Ladeeinrichtung bereitgestellt werden, in welchem Zeitfenster elektronische Bauelemente aus einem anderen in der Bereitstellungseinrichtung bereitgestellten Flächenmagazin entnommen werden.

Durch eine derartige zeitliche Synchronisation zwischen einem Flächenmagazin-Austausch in der Ladeeinrichtung und einer Bauelemententnahme aus einem in der Bereitstellungseinrichtung befindlichen Flächenmagazin kann auf zuverlässige Weise eine unterbrechungsfreie Bauelementzuführung mit hoher Prozesssicherheit gewährleistet werden.

Mit dem nebengeordneten Anspruch 11 wird ein Bestücksystem zum Bestücken von Bauelementeträgern mit elektronischen Bauelementen beschrieben. Das Bestücksystem weist auf (a) einen Bestückautomaten mit einem Bestückkopf zum Aufnehmen, Transportieren und Aufsetzen von elektronischen Bauelementen an vorgegebenen Positionen eines Bauelementeträgers, und (b) eine Flächenmagazin-Bereitstellungsvorrichtung gemäß einem der oben beschriebenen Ausführungsbeispiele. Die Vorrichtung ist relativ zu einem Chassis des Bestückautomaten derart angeordnet, dass elektronische Bauelemente aus einem mittels der Vorrichtung bereitgestellten Flächenmagazin unter Verwendung des Bestückkopfes entnehmbar sind.

Dem beschriebenen Bestücksystem liegt die Erkenntnis zugrunde, dass die für einen Bestückprozess erforderlichen Bauelemente auf vorteilhafte Weise mittels der oben beschriebenen Flächenmagazin-Bereitstellungsvorrichtung einem herkömmlichen Bestückautomaten zur Verfügung gestellt werden können. Das gesamte Bestücksystem kann auf vorteilhafte Weise innerhalb einer vergleichsweise geringen Stellfläche aufgebaut werden, so dass die effektiven Kosten einer gesamten Bestückanlage, welche Kosten auch Betriebskosten wie beispielsweise Raummiete und dergleichen umfassen, gering gehalten werden können.

Mit dem unabhängigen Anspruch 12 wird ein Verfahren zum Bereitstellen von Flächenmagazinen beschrieben, wobei die oben beschriebene Flächenmagazin-Bereitstellungsvorrichtung verwendet wird. Das Verfahren umfasst folgende Schritte: (a) Beladen der Ladeeinrichtung mit einem ersten Flächenmagazin, (b) Transferieren des ersten Flächenmagazins an eine Speicherposition der Speichereinrichtung, (c) Transferieren eines zweiten Flächenmagazins von der Speichereinrichtung an die Bereitstellungseinrichtung, (d) Entnehmen von elektronischen Bauelementen aus dem zweiten Flächenmagazin, (e) Transferieren eines auszutauschenden dritten Flächenmagazins von der Speichereinrichtung zu der Ladeeinrichtung, (f) Entladen des dritten Flächenmagazins aus der Ladeeinrichtung und (g) Beladen der Ladeeinrichtung mit einem vierten Flächenmagazin. Dabei erfolgen das Transferieren und das Entladen des dritten Flächenmagazins sowie das Beladen der Ladeeinrichtung mit dem vierten Flächenmagazin gerade dann, wenn elektronische Bauelemente aus dem zweiten, in der Bereitstellungsvorrichtung bereitgestellten Flächenmagazin entnommen werden.

Dem beschriebenen Verfahren liegt die Erkenntnis zugrunde, dass ein Bestückbetrieb eines Bestückautomaten, welcher mit der Flächenmagazin-Zuführvorrichtung gekoppelt ist, auch dann nicht unterbrochen werden muss, wenn zumindest teilweise entleerte Flächenmagazine von der Ladeeinrichtung entfernt und/oder neue zumindest teilweise mit elektronischen Bauelementen befüllte Flächenmagazine an der Ladeeinrichtung zur Verfügung gestellt werden. Das Ein- bzw. Ausschleusen von Flächenmagazinen erfolgt nämlich genau dann, wenn sich ein Flächenmagazin zum Zwecke der Entnahme von Bauelementen gerade in der Bereitstellungseinrichtung befindet.

Da sich in der Praxis verschiedene Flächenmagazine typischerweise unterschiedlich lang in der Bereitstellungseinrichtung befinden, kann der optimale Zeitpunkt für einen Austausch von Flächenmagazinen an der Ladeeinrichtung von der Maschinensteuerung des Bestückautomaten ermittelt werden. Da die Verweilzeit der einzelnen Flächenmagazine somit unter anderem von dem Bestückinhalt der zu bestückenden Bauelementeträger abhängt, eignet sich die Maschinensteuerung des Bestückautomaten in besonderem Maße, um eine geeignete möglichst lange Zeitspanne zum Austausch eines Flächenmagazins an der Ladeeinrichtung rechtzeitig zu identifizieren.

Das beschriebene Verfahren ermöglicht eine gewisse Entkopplung zwischen der Bereitstellungseinrichtung und der Ladeeinrichtung, so dass in jeweils unterschiedlichen Zeitfenstern auf der einen Seite ein Austausch von Flächenmagazinen zwischen der Speichereinrichtung und der Bereitstellungseinrichtung und auf der anderen Seite ein Austausch von Flächenmagazinen zwischen der Speichereinrichtung und der Ladeeinrichtung erfolgen kann. Durch ein derart geschicktes Zeitmanagement dieser beiden Austauschvorgänge kann eine besonders hohe Bestückleistung eines Bestückautomaten gewährleistet werden.

Das beschriebene Verfahren hat ferner den Vorteil, dass es ohne großen apparativen Umbauaufwand mit bereits bekannten Flächenmagazin-Zuführvorrichtungen ausgeführt werden kann. Ein entsprechender Umbau erfordert lediglich sehr geringe Mehrkosten.

Gemäß einem Ausführungsbeispiel der Erfindung nach Anspruch 13 umfasst das Verfahren zusätzlich den Schritt des Anbringens einer Markierung an zumindest einem Trägerelement für ein Flächenmagazin, welche Markierung eine bestimmte Speicherposition in der Speichereinrichtung bezeichnet, in der das jeweilige Flächenmagazin gespeichert werden soll. Die Markierung kann dabei ein Klartext und/oder ein Strichcode sein.

Mittels eines entsprechenden Lesegerätes kann somit eine Zuordnung zwischen einem bestimmten Flächenmagazin bzw. einem bestimmten Bauelement-Typ und einer bestimmten Speicherposition festgelegt und ggf. überprüft werden. Auf diese Weise kann die Prozesssicherheit erheblich gesteigert werden, da jederzeit überprüfbar ist, ob sich auch tatsächlich ein Flächenmagazin mit bestimmen elektronischen Bauelementen in der richtigen Speicherposition befindet. Die Gefahr von Fehlbestückungen durch das Aufsetzen von falschen Bauelement-Typen an bestimmte Bauelement-Einbaupositionen wird somit bereits vor der Bauelement-Aufnahme durch einen Bestückkopf erheblich reduziert.

Im Falle einer Speichereinrichtung, bei der die einzelnen Trägerelemente bzw. Flächenmagazine in einer vertikalen Anordnung übereinander angeordnet sind, kann die Markierung die Ebenennummer innerhalb der Speichereinrichtung bezeichnen.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.
- Figur 1: zeigt in einer vertikalen Schnittebene ein Bestücksystem mit einem Bestückautomaten und einer Flächenmagazin-Bereitstellungsvorrichtung, welche eine Ladeeinrichtung, eine Speichereinrichtung und eine Bereitstellungseinrichtung umfasst.
- Figur 2: zeigt in einer horizontalen Schnittebene die in Figur 1 dargestellte Flächenmagazin-Bereitstellungsvorrichtung.

An dieser Stelle bleibt anzumerken, dass sich in der Zeichnung die Bezugszeichen von gleichen oder von einander entsprechenden Komponenten lediglich in ihrer ersten Ziffer unterscheiden.

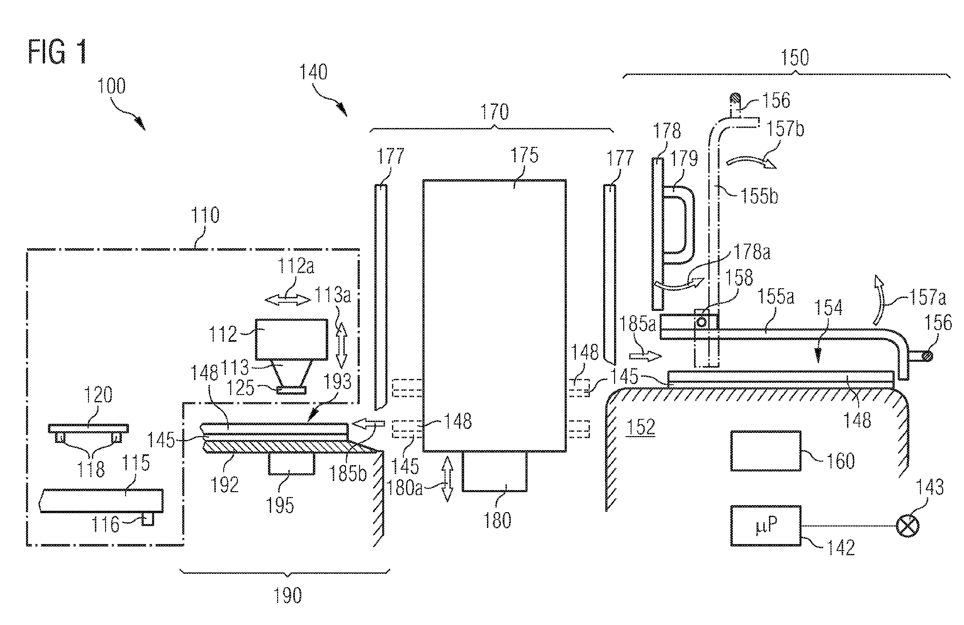

Figur 1 zeigt ein Bestücksystem 100 gemäß einem Ausführungsbeispiel der Erfindung in einer vertikalen Schnittebene. Das Bestücksystem 100 umfasst einen Bestückautomaten 110 und eine Flächenmagazin-Bereitstellungsvorrichtung 140.

Der Bestückautomat 110 weist einen Bestückkopf 112 auf, an dem eine als Saugpipette ausgebildete Bauelement-Haltevorrichtung 113 angebracht ist. Der Bestückkopf 112 ist mittels eines nicht dargestellten Positioniersystems relativ zu einem Chassis 115 des Bestückautomaten 110 entlang einer horizontalen Verschieberichtung 112a verschiebbar. Die Saugpipette 113 ist relativ zu dem Bestückkopf 112 entlang einer vertikalen Verschieberichtung 113a verschiebbar. Damit muss weder zum Aufnehmen eines Bauelements 125 noch zum Absetzen des Bauelements 125 auf einen Bauelementeträger 120 der gesamte Bestückkopf 112 abgesenkt bzw. angehoben werden.

Der Bestückautomat 110 weist ferner ein Transportsystem 118 auf. Das Transportsystem 118 kann ein übliches Förderband sein, mit dem in bekannter Weise Bauelementeträger 120 in einen Bestückbereich des Bestückautomaten 110 eingefahren und nach erfolgter Bestückung wieder aus dem Bestückbereich herausgefahren werden können.

An der Unterseite des Chassis 115 sind Maschinenfüße 116 angebracht, welche einen sicheren Stand des Bestückautomaten 110 auf einer nicht dargestellten Standfläche ermöglichen.

Die Flächenmagazin-Bereitstellungsvorrichtung 140 weist eine Ladeeinrichtung 150, eine Speichereinrichtung 170 und eine Bereitstellungseinrichtung 190 auf.

Die Ladeeinrichtung 150 weist ein Chassis 152 auf, an dessen Oberseite ein Ladeschacht 154 angeordnet ist. Aus dem Ladeschacht 154 kann ein Flächenmagazin 148, welches von der Speichereinrichtung 170 ausgeschleust worden ist, von einer Bedienperson herausgenommen werden und gegen ein anderes Flächenmagazin ausgetauscht werden, welches nachfolgend in die Speichereinrichtung 170 eingelagert werden kann.

Eine Steuereinrichtung 142, welche den gesamten Betrieb der Flächenmagazin-Bereitstellungsvorrichtung 140 steuert bzw. regelt, ist mit einer Anzeigeeinrichtung 143 gekoppelt. Die Anzeigeeinrichtung 143 ist dafür vorgesehen, einer Bedienperson anzuzeigen, wenn in dem Ladeschacht 154 ein Flächenmagazin 148 zum Austausch bereit liegt. Die Anzeigeeinrichtung 143 kann akustische und/oder optische Signale aussenden.

Die Flächenmagazine 148 sind an einem Trägerelement 145 lösbar befestigt. Die lösbare Befestigung erfolgt gemäß dem hier dargestellten Ausführungsbeispiel mittels nicht dargestellter Magnete. Die Magnete werden von dem Trägerelement 145 magnetisch angezogen, welches Trägerelement 145 aus einem dünnen magnetischen Blech hergestellt ist. Somit wird das jeweilige Flächenmagazin 148 zwischen den Magneten und dem Trägerblech 145 eingeklemmt.

Die Ladeeinrichtung 150 weist ein mechanisches Abschirmelement 155a auf, welches in einer geschlossenen Position verhindert, dass eine nicht dargestellte Bedienperson versehentlich in den Ladeschacht 154 hinein greift. Der Ladeschacht 154 ist nach oben nicht nur durch das Abschirmelement 155a sondern auch durch ein Verkleidungselement 153 von der Umgebung abgetrennt. Gemäß dem hier dargestellten Ausführungsbeispiel ist das mechanische Abschirmelement ein Schutzschild bzw. eine Abdeck-Klappe 155a, welche um eine Drehachse 158 schwenkbar ist. Das Bezugszeichen 155b deutet die Abdeck-Klappe 155b in der Öffnungsposition an. Ein Griff 156 an der Abdeck-Klappe 155a bzw. 155b erleichtert sowohl das manuelle Öffnen der Abdeck-Klappe 155a als auch das manuelle Schließen der Abdeck-Klappe 155b. Der Pfeil 157a verdeutlicht eine Öffnungsbewegung der Abdeck-Klappe 155a. Der Pfeil 157b verdeutlicht eine Schließbewegung der Abdeck-Klappe 155b.

Da ein Öffnen der Abdeck-Klappe 155a im regulären Betrieb der Flächenmagazin-Bereitstellungsvorrichtung 100 für jeden Austausch eines zumindest teilweise entleerten Flächenmagazins 148 erforderlich ist, ist die Abdeck-Klappe 155a bzw. 155b nicht mit einem Sicherheitssystem 160 gekoppelt, welches beim Auftreten eines fehlerhaften Betriebszustandes oder bei Gefahr in Verzug die gesamte Flächenmagazin-Bereitstellungsvorrichtung 100 anhält. Dies gilt nicht für eine Tür 178, die an der Speichereinrichtung 170 vorgesehen ist und die beispielsweise für eine Kontrolle der Speichereinrichtung 170 geöffnet wird.

Um eine mechanische Beschädigung der Speichereinrichtung 170 und/oder eine Verletzung einer Bedienperson zu vermeiden, führt ein Öffnen 178a der Tür 178, welche ebenfalls einen Griff 179 aufweist, zu einem entsprechenden Signal. Dieses veranlasst das Sicherheitssystem 160, den Betrieb der gesamten Flächenmagazin-Bereitstellungsvorrichtung 100 einzustellen.

Die Speichereinrichtung 170 weist einen Container bzw. einen Speicherturm 175 auf, in dem mehreren Flächenmagazine 148 zusammen mit einem entsprechenden Trägerelement 145 übereinander eingeschoben werden können. Dazu sind eine Vielzahl von nicht dargestellten Führungsnuten vorgesehen, die entsprechend dem Prinzip einer Schublade ein einfaches horizontales Verschieben der Trägerelemente 145 bzw. der Flächenmagazine 148 ermöglichen. Eine derartige stapelartige Anordnung der Flächenmagazine 148 zusammen mit den Trägerelementen 145 hat den Vorteil, dass die Flächenmagazine 148 auf besonders Platz sparende Weise in dem Speicherturm 175 aufbewahrt werden können. Um eine besonders kompakte Aufbewahrung zu ermöglichen, kann der Teilungsabstand der Führungsnuten an die jeweilige Höhe der Flächenmagazine 148 angepasst sein.

Die Speichereinrichtung 170 weist ferner eine Hub- und Senkeinrichtung 180 auf, mittels welcher der Container 175 vertikal entlang der durch den Pfeil 180a dargestellten Bewegungsrichtung verschoben werden kann. Somit kann eine bestimmte Speicherposition, die durch zwei in gleicher Höhe ausgebildete Führungsnuten definiert ist, auf die gleiche Höhe wie die obere Auflagefläche des Chassis 152 der Ladeeinrichtung 150 gebracht werden. Damit kann ein Flächenmagazin 148 durch eine einfache horizontale Verschiebebewegung 185a von dem Speicherturm 175 in den Ladeschacht 154 transferiert werden. Das gleiche gilt selbstverständlich für einen Transfer eines in den Ladeschacht 154 eingelegten Flächenmagazins 148 in den Container 175.

Die Speichereinrichtung 170 weist außerdem einen Gleitanschlag 177 auf. Der Gleitanschlag umfasst zwei Leisten, die in Bezug zu dem Container 175 auf zwei gegenüberliegenden Seiten angebracht sind. Die Leisten verhindern ein versehentliches Herausrutschen von Flächenmagazinen 148 aus dem Container 175.

Wie aus Figur 1 ersichtlich, weist die Ladeeinrichtung 150 zusätzlich ein Trennelement 165 auf. Gemäß dem hier dargestellten Ausführungsbeispiel ist das Trennelement ein Trennschieber 165, welcher entlang einer vertikalen Verschieberichtung 167 mittels eines nicht dargestellten Hubmagnetes oder eines beliebigen anderen Antriebs geöffnet und geschlossen werden kann. In der dargestellten Schließposition trennt der Trennschieber 165 den Ladeschacht 154 von der Speichereinrichtung 170 ab.

Gemäß dem hier dargestellten Ausführungsbeispiel ist auch das Trennelement 165 mit dem Sicherheitssystem 160 gekoppelt. Das Sicherheitssystem 160 kann dann durch eine Sicherheitsabfrage überprüfen, ob eventuell sowohl die Abdeck-Klappe 155b als auch der Trennschieber 165 geöffnet ist. In diesem Fall muss dann eine Betriebsunterbrechung veranlasst werden, so dass eine Gefährdung von einer Bedienperson zuverlässig ausgeschlossen ist. Eine derartige Gefährdung könnte beispielsweise bei einem manuellen Beladen oder Entladen von Flächenmagazinen 148 erfolgen, wenn genau zu diesem Zeitpunkt ein Flächenmagazin 148 irrtümlich aus der Speichereinrichtung 170 ausgeschleust wird. Falls lediglich entweder ausschließlich die Abdeck-Klappe 155b oder ausschließlich das Trennelement 165 geöffnet ist, erfolgt keine Betriebsunterbrechung der Flächenmagazin-Bereitstellungsvorrichtung.

Die Zeiträume, in denen die Abdeck-Klappe 155b geöffnet werden kann, ohne eine Betriebsunterbrechung zu verursachen, kann über eine Anzeigeeinrichtung wie beispielsweise einen Leuchttaster angezeugt werden. Damit kann eine Bedienperson auf einfache Weise darüber informiert werden, wann ein manuelles Beladen bzw. Entladen von Flächenmagazinen 148 durchgeführt werden kann.

Der Trennschieber kann zudem derart ausgebildet sein, dass er in der Schließposition ein versehentliches Herausrutschen eines Flächenmagazins aus dem Container 175 verhindert. Dies gilt insbesondere, wenn der Container 175 gerade vertikal verfahren wird. Außerdem kann der Trennschieber 165 als Anschlag für Flächenmagazine 148 bzw. Trägerelemente 145 dienen, die in den Ladeschacht 154 eingelegt werden. Somit kann auf effektive Weise ein falsches Einlegen vom Flächenmagazine 148 bzw. Trägerelemente 145 in den Ladeschacht 154 verhindert werden.

Die Bereitstellungseinrichtung 190 weist eine Auflage 192 auf, welche auch als so genannte Zuführachse bezeichnet wird. Auf dieser kann jeweils ein Flächenmagazin 148 bereitgestellt werden, so dass die in dem Flächenmagazin 148 aufbewahrten Bauelemente 125 von dem Bestückkopf 112 des Bestückautomaten 110 entnommen werden können. Die Bereitstellung des jeweiligen Flächenmagazins 148 erfolgt an einer Bereitstellungsposition 193.

Das Bereitstellen eines Flächenmagazins 148 kann dabei eine erneute Hubbewegung 180a des Containers 175 umfassen, so dass sich am Ende der Hubbewegung 180a das entsprechende noch in dem Container 175 befindliche Flächenmagazin 148 auf der gleichen Höhe wie die Zuführachse 192 befindet. Damit kann ein Transfer dieses Flächenmagazins 148 durch eine weitere rein horizontale Verschiebung 185b erfolgen. Das gleiche gilt selbstverständlich auch für eine gegenläufige Verschiebebewegung von der Zuführachse 192 zurück in den Container 175.

Die Bereitstellungsposition 193 kann bei Bedarf mittels eines Antriebs 195 variiert werden, so dass das bereitgestellte Flächenmagazin 148 schrittweise verschiebbar ist. Damit können die zu entnehmenden elektronischen Bauelemente, welche sich noch in dem Flächenmagazin 148 befinden, in definierte Abholpositionen bewegt werden. Auf diese Weise können die Verfahrwege des Bestückkopfes erheblich reduziert werden, so dass die Bestückleistung infolge von reduzierten Transportzeiten des Bestückkopfes erhöht wird.

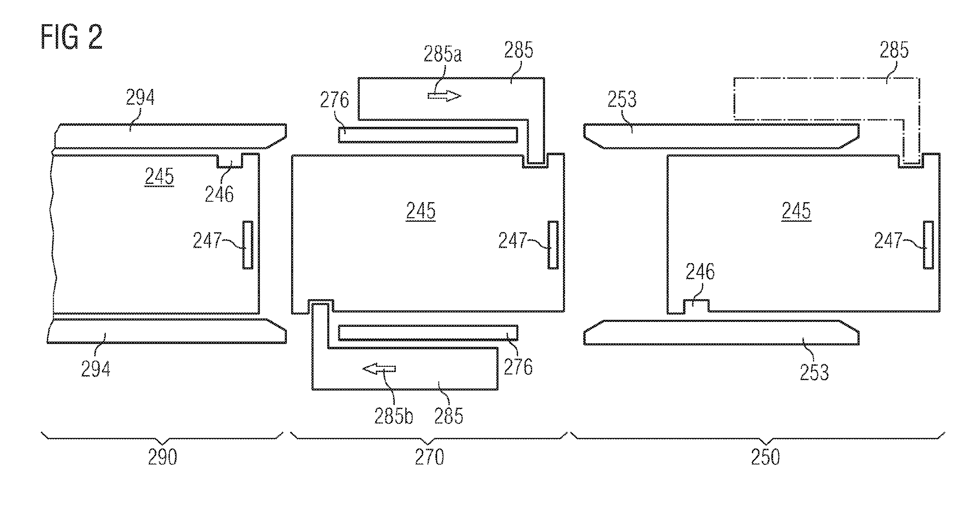

Figur 2 zeigt in einer horizontalen Schnittebene die Flächenmagazin-Bereitstellungsvorrichtung 140, die nun mit dem Bezugszeichen 240 gekennzeichnet ist. Zu erkennen sind verschiedene Trägerelemente 245, an denen jeweils ein nicht dargestelltes Flächenmagazin lösbar befestig werden kann. Ein Trägerelement 245 befindet sich in der Ladeeinrichtung 250, ein Trägerelement 245 befindet sich in der Speichereinrichtung 270 und ein Trägerelement 245 befindet sich in der Bereitstellungseinrichtung 290. Führungswangen 253, 276 und 294 verhindern jeweils ein seitliches Verrutschen der Trägerelemente 245.

Die Trägerelemente 245 weisen jeweils eine Aussparung 246 auf, so dass eine horizontale Verschiebebewegung der Trägerelemente 245 auf einfache Weise durch einen Eingriff eines Mitnehmerelements 285 erfolgen kann. Das Mitnehmerelement 285 wird dabei durch einen aus Gründen der Übersicht nicht dargestellten Antrieb bewegt. Der Pfeil 285a illustriert eine Verschiebebewegung des Trägerelements 245 von der Speichereinrichtung 270 hin zu der Ladeeinrichtung 250. Diese Verschiebebewegung 285a wird unter Verwendung des oberen Mitnehmerelements 285 erzeugt. Der Pfeil 285b illustriert eine Verschiebebewegung des Trägerelements 245 von der Speichereinrichtung 270 hin zu der Bereitstellungseinrichtung 290. Diese Verschiebebewegung 285b wird unter Verwendung des unteren Mitnehmerelements 285 erzeugt.

Wie ferner aus Figur 2 ersichtlich, sind die Trägerelemente 245 mit einer Markierung 247 versehen. Gemäß dem hier dargestellten Ausführungsbeispiel bezeichnet diese Markierung 247 eine bestimmte Speicherposition in dem Speicherturm 175, in der das jeweilige Flächenmagazin gespeichert werden soll. Die Markierung 247 kann ein Klartext und/oder ein Strichcode sein. Gemäß dem hier dargestellten Ausführungsbeispiel der Erfindung bezeichnet die Markierung 247 eine Nummer der Ebene bzw. der Speicherposition innerhalb der Speichereinrichtung 270, in welcher Ebene das jeweilige Trägerelement 245 eingelagert werden soll. Auf diese Weise kann insbesondere bei Verwendung eines entsprechenden Lesegerätes der Betrieb der gesamten Flächenmagazin-Bereitstellungsvorrichtung 240 überwacht werden.

Im Folgenden wird unter Bezugnahme insbesondere auf Figur 1 ein bevorzugter Betriebsmodus der Flächenmagazin-Bereitstellungsvorrichtung 140 kurz erläutert: Zunächst werden verschiedene Flächenmagazine 148, die ggf. unterschiedliche Bauelemente 125 enthalten, über den Ladeschacht 154 in den Speicherturm 175 eingelagert. Von dem Speicherturm 175 werden die Flächenmagazine 148 dann nacheinander entsprechend einen von dem Bestückautomaten 110 abzuarbeitendem Bestückprogramm auf der Zuführachse 192 bereitgestellt. Das sequentielle Bereitstellen der unterschiedlichen Flächenmagazine 148 erfordert jeweils einen Austausch von Flächenmagazinen 148, wobei das auf der Zuführachse 192 bereitgestellte Flächenmagazin 148 in den Speicherturm 175 eingefahren und ein in dem Speicherturm 175 befindliches Flächenmagazin 148 auf die Zuführachse 192 transferiert wird. Abhängig von der jeweils beteiligten Speicherposition wird dazu der Speicherturm 175 mittels des Liftes 180 entsprechend angehoben bzw. abgesenkt.

Bei einer vollständigen Entleerung eines Flächenmagazins 148 wird dieses indirekt über den Speicherturm 175 in den Ladeschacht 154 transferiert. Der Transfer zwischen dem Speicherturm 175 und dem Ladeschacht 154 erfolgt dabei innerhalb einer Zeitspanne, in der gerade ein anderes Flächenmagazin 148 auf der Zuführachse bereitgestellt ist, so dass von dem Bestückkopf 112 Bauelemente 125 entnommen werden können. Ein Austausch von ggf. vollständig entleerten Flächenmagazinen 148 gegen neue Flächenmagazine in dem Ladeschacht 154 kann ebenfalls innerhalb dieser Zeitspanner erfolgen, ohne dass der Bestückbetrieb unterbrochen werden muss. Auf diese Weise kann die effektive Bestückleistung des Bestückautomaten 110 erheblich gesteigert werden.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Bestücksystem
- 110: Bestückautomat
- 112: Bestückkopf
- 112a: Horizontalbewegung Bestückkopf
- 113: Haltevorrichtung / Saugpipette
- 113a: Vertikalbewegung Haltevorrichtung
- 115: Chassis
- 116: Stellfuß
- 118: Transportsystem
- 120: Bauelementeträger
- 125: Bauelement
- 140: Flächenmagazin-Bereitstellungsvorrichtung
- 142: Steuereinrichtung
- 143: Anzeigeeinrichtung
- 145: Trägerelement
- 148: Flächenmagazin
- 150: Ladeeinrichtung
- 152: Chassis
- 153: Verkleidungselement
- 154: Ladeschacht
- 155a: mechanisches Abschirmelement / Schutzschild / Abdeck-Klappe (Schließposition)
- 155b: mechanisches Abschirmelement / Schutzschild / Abdeck-Klappe (Öffnungsposition)
- 156: Griff
- 157a: Öffnungsbewegung
- 157b: Schließbewegung
- 158: Drehachse
- 160: Sicherheitssystem
- 165: Trennelement, Trennschieber
- 167: Öffnungsbewegung
- 170: Speichereinrichtung
- 175: Container / Speicherturm
- 177: Gleitanschlag
- 178: Tür
- 178a: Öffnungsbewegung
- 179: Griff
- 180: Hub- und Senkeinrichtung / Lift
- 180a: Hubbewegung
- 185a: Verschieberichtung Ausschleusen
- 185b: Verschieberichtung Bereitstellen
- 190: Bereitstellungseinrichtung
- 192: Auflage / Zuführachse
- 193: Bereitstellungsposition
- 195: Antrieb

- 240: Flächenmagazin-Bereitstellungsvorrichtung
- 245: Trägerelement
- 246: Aussparung
- 247: Markierung
- 250: Ladeeinrichtung
- 253: Führungswange
- 270: Speichereinrichtung
- 276: Führungswange
- 285: Mitnehmerelement
- 285a: Verschieberichtung Ausschleusen
- 285b: Verschieberichtung Bereitstellen
- 290: Bereitstellungseinrichtung
- 294: Führungswange

## Patentansprüche

1. Vorrichtung zum Bereitstellen von Flächenmagazinen (148), insbesondere zum temporären Bereitstellen von mit elektronischen Bauelementen (125) beladenen Flächenmagazinen (148) für einen Bestückautomaten (110) zum Zwecke der automatischen Bestückung von Bauelementeträgern (120) mit elektronischen Bauelementen (125), die Vorrichtung aufweisend
• eine Ladeeinrichtung (150) zum Beladen und Entladen von Flächenmagazinen (148),
• eine Speichereinrichtung (170), welche eine Mehrzahl von Speicherpositionen zum Speichern jeweils eines Flächenmagazins (148) aufweist, wobei die Speichereinrichtung (170) mit der Ladeeinrichtung (150) derart gekoppelt ist, dass Flächenmagazine (148) zwischen der Ladeeinrichtung (150) und verschiedenen Speicherpositionen transferierbar sind,
• eine Bereitstellungseinrichtung (190), welche mit der Speichereinrichtung (170) derart gekoppelt ist, dass Flächenmagazine (148) zwischen verschiedenen Speicherpositionen und einer Bereitstellungsposition (193) der Bereitstellungseinrichtung (190) transferierbar sind, und
• wobei die Ladeeinrichtung (150), die Speichereinrichtung (170) und die Bereitstellungseinrichtung (190) derart ausgestaltet sind, dass ein Austausch von Flächenmagazinen (148) zwischen der Ladeeinrichtung (150) und der Speichereinrichtung (170) in einem Zeitfenster durchführbar ist, in welchem elektronische Bauelementen aus einem anderen in der Bereitstellungseinrichtung (190) bereitgestellten Flächenmagazin (148) entnommen werden.

2. Vorrichtung nach Anspruch 1, wobei
die Ladeeinrichtung (150) und die Bereitstellungseinrichtung (190) in Bezug auf die Speichereinrichtung (170) auf einander gegenüberliegenden Seiten angeordnet sind.

3. Vorrichtung nach einem der Ansprüche 1 bis 2, wobei
die verschiedenen Speicherpositionen zueinander in vertikaler Richtung übereinander angeordnet sind.

4. Vorrichtung nach Anspruch 3, zusätzlich aufweisend
• eine Heb- und Senkeinrichtung (180) zum vertikalen Verschieben der Speichereinrichtung (170) in Bezug auf die Ladeeinrichtung (150) und/oder in Bezug auf die Bereitstellungseinrichtung (190).

5. Vorrichtung nach einem der Ansprüche 1 bis 4, bei der die Ladeeinrichtung (150) ein mechanisches Abschirmelement (155a, 155b) aufweist,
- welches in einer Öffnungsposition ein einfaches Be- und Entladen von Flächenmagazinen (148) durch eine Bedienperson ermöglicht und
- welches in einer Schließposition ein mechanisches Schutzschild (155a) darstellt.

6. Vorrichtung nach Anspruch 5, zusätzlich aufweisend
• ein Sicherheitssystem (160), welches mit dem mechanischen Schutzschild (155a, 155b) gekoppelt ist und welches derart eingerichtet ist, dass bei geöffnetem mechanischen Schutzschild (155b) ein Transfer eines Flächenmagazins (148) von der Speichereinrichtung (170) zu der Ladeeinrichtung (150) verhindert wird.

7. Vorrichtung nach einem der Ansprüche 1 bis 6, bei der die Ladeeinrichtung (150) ein mechanisches Trennelement (165) aufweist,
- welches zwischen einer Öffnungsposition und einer Schließposition bewegbar ist und
- welches in der Schließposition einen Ladebereich (154) der Ladeeinrichtung (150) von der Speichereinrichtung (170) abtrennt.

8. Vorrichtung nach einem der Ansprüche 1 bis 7, zusätzlich aufweisend
• eine Anzeigeeinrichtung (143), welche mit der Ladeeinrichtung (150) gekoppelt und derart eingerichtet ist, dass einer Bedienperson ein Signal angezeigt wird, wenn sich ein zu entnehmendes Flächenmagazin (148) in der Ladeeinrichtung (150) befindet.

9. Vorrichtung nach einem der Ansprüche 1 bis 8, bei der die Bereitstellungseinrichtung (190) einen Antrieb (195) aufweist, welcher derart eingerichtet ist, dass ein bereitgestelltes Flächenmagazin (148) schrittweise verschiebbar ist.

10. Vorrichtung nach einem der Ansprüche 1 bis 9, zusätzlich aufweisend
• eine Steuereinrichtung (142) welche derart eingerichtet ist, dass Flächenmagazine (148) zum Zwecke eines Austauschs in der Ladeeinrichtung (150) jeweils in einem Zeitfenster in der Ladeeinrichtung (150) bereitgestellt werden, in welchem Zeitfenster elektronische Bauelemente (125) aus einem anderen in der Bereitstellungseinrichtung (190) bereitgestellten Flächenmagazin (148) entnommen werden.

11. Bestücksystem zum Bestücken von Bauelementeträgern (120) mit elektronischen Bauelementen (125), das Bestücksystem (100) aufweisend
• einen Bestückautomaten (110) mit einen Bestückkopf (112) zum Aufnehmen, Transportieren und Aufsetzen von elektronischen Bauelementen (125) an vorgegebenen Positionen eines Bauelementeträgers (120), und
• eine Vorrichtung (140) nach einem der Ansprüche 1 bis 10, wobei
die Vorrichtung (140) relativ zu einem Chassis (115) des Bestückautomaten (110) derart angeordnet ist, dass elektronische Bauelemente (125) aus einem mittels der Vorrichtung (140) bereitgestellten Flächenmagazin (148) unter Verwendung des Bestückkopfes (112) entnehmbar sind.

12. Verfahren zum Bereitstellen von Flächenmagazinen (148) unter Verwendung der Vorrichtung (140) nach einem der Ansprüche 1 bis 11, das Verfahren aufweisend
• Beladen der Ladeeinrichtung (150) mit einem ersten Flächenmagazin (148),
• Transferieren des ersten Flächenmagazins (148) an eine Speicherposition der Speichereinrichtung (170),
• Transferieren eines zweiten Flächenmagazins (148) von der Speichereinrichtung (170) an die Bereitstellungseinrichtung (190),
• Entnehmen von elektronischen Bauelementen (125) aus dem zweiten Flächenmagazin (148),
• Transferieren eines auszutauschenden dritten Flächenmagazins (148) von der Speichereinrichtung (170) zu der Ladeeinrichtung (150),
• Entladen des dritten Flächenmagazins (148) aus der Ladeeinrichtung (150) und
• Beladen der Ladeeinrichtung (150) mit einem vierten Flächenmagazin (148),
wobei
das Transferieren und das Entladen des dritten Flächenmagazins (148) sowie das Beladen der Ladeeinrichtung (150) mit dem vierten Flächenmagazin (148) gerade dann erfolgt, wenn elektronische Bauelemente (125) aus dem zweiten, in der Bereitstellungsvorrichtung (190) bereitgestellten Flächenmagazin (148) entnommen werden.

13. Verfahren nach Anspruch 12, zusätzlich aufweisend
• Anbringen einer Markierung (247) an zumindest einem Trägerelement (145, 245) für ein Flächenmagazin (148), welche Markierung (247) eine bestimmte Speicherposition in der Speichereinrichtung (170) bezeichnet, in der das jeweilige Flächenmagazin (148) gespeichert werden soll.
